# EUROPEAN PATENT APPLICATION

(11) **EP 4 394 951 A1**
(43) Date of publication of application: **03.07.2024**
(21) Application number: 22861520.9
(22) Date of filing: 13.06.2022
(51) Int. Cl.: H01M 4/66, H01M 4/134, H01M 4/1395, H01M 4/04, H01M 4/40, H01M 4/38, H01M 10/052, H01M 12/08

(54) **ANODE CURRENT COLLECTOR AND METAL BATTERY COMPRISING SAME**

(30) Priority: 25.08.2021 KR 20210112564
(71) Applicant: NEXTERIALS CO., LTD., Ulju-gun Ulsan 44919 (KR)
(72) Inventor: SHIN, Hyeon Suk, Ulju-gun Ulsan 44919 (KR); KIM, Min Su, Ulju-gun Ulsan 44919 (KR)
(74) Representative: ZBM Patents - Zea, Barlocci & Markvardsen
(86) International application number: PCT/KR2022/008265
(87) International publication number: WO 2023/027306

(57) **Abstract**

The present invention relates to an anode current collector and a metal battery comprising same, and, more specifically, to an anode current collector and a metal battery comprising same, the anode current collector comprising: a current collector substrate; an amorphous boron nitride layer formed on at least one portion of the current collector substrate; and a metal-containing layer formed on at least one portion of the amorphous boron nitride layer.

## Description

### Technical Field

The present disclosure relates to an anode current collector and a metal battery including the same.

### Background Art

Lithium secondary batteries, which exhibit the best energy density and output characteristics, have been widely commercialized. As the demand for electric vehicles and large-capacity power storage devices increases, various batteries capable of satisfying the demand have been developed. An analysis result shows that a lithium metal anode needs to be applied to realize an energy density of at least 400 watt-hours per kilogram (Wh/kg), and the development of technologies of using lithium metal as an anode to enhance the energy density of a secondary battery is actively ongoing.

Lithium metal batteries, which are secondary batteries that use lithium metal with a high capacity and low reduction potential as an anode, are being studied and developed in various forms such as lithium-air batteries or lithium-sulfur batteries, and are in the limelight as a next-generation energy battery system with a high energy density.

If lithium metal is used as an anode, a lithium layer with a dendrite structure may be formed in a process of depositing the lithium metal on a surface of a current collector. If lithium dendrites grow due to such a non-uniform lithium layer, a short circuit phenomenon may occur and dead Li, which does not contribute to the capacity, may be formed. In addition, due to the above lithium layer with the dendrite structure, a phenomenon in which the capacity and output characteristics of a battery are reduced occurs, which may lead to a difficulty in commercializing a lithium metal battery.

To overcome such issues, the development of technologies for forming a uniform lithium layer on a surface of a current collector is emerging, however, it is difficult to technically control a uniform lithium nucleation due to high nucleation overpotentials of the surface of the current collector.

### Disclosure of the Invention

### Technical Goals

To solve the above-mentioned problems, the present disclosure is to provide an anode current collector that has a surface modified with a metal affinity material and that may form a uniform and dense metal-containing layer.

The present disclosure is to provide a metal battery that includes the anode current collector according to the present disclosure and that may realize a metal-based high energy density.

The present disclosure is to provide a method of manufacturing an anode current collector that has a surface treated with a metal affinity material having an atomic thickness.

However, the technical goal obtainable from the present disclosure is not limited to those described above, and other goals not mentioned above can be clearly understood by one of ordinary skill in the art to which the present disclosure pertains from the following description.

### Technical Solutions

According to an embodiment of the present disclosure, there is provided an anode current collector including: a current collector substrate; an amorphous boron nitride layer formed on at least one portion of the current collector substrate; and a metal-containing layer formed on at least one portion of the amorphous boron nitride layer.

According to an embodiment of the present disclosure, the current collector substrate may include at least one selected from a group consisting of Ni, Cu, Ti, V, Cr, Mn, Fe, Co, Zn, Mo, W, Ag, Au, Ru, Pt, Ir, Li, Al, Sn, Bi, Sb, and an alloy thereof; calcined carbon; and stainless steel.

According to an embodiment of the present disclosure, the current collector substrate may include a first component including Cu, Ni, Ti, stainless steel, or Al; and a second component (excluding the same element as in the first component) including at least one selected from a group consisting of Ni, Cu, Ti, V, Cr, Mn, Fe, Co, Zn, Mo, W, Ag, Au, Ru, Pt, Ir, Li, Al, Sn, Bi, Sb, and an alloy thereof.

According to an embodiment of the present disclosure, the amorphous boron nitride layer may have a thickness of 10 nanometers (nm) or less.

According to an embodiment of the present disclosure, the amorphous boron nitride layer may have a thickness of 0.1 nm to 1 nm.

According to an embodiment of the present disclosure, the amorphous boron nitride layer may have an atomic thickness.

According to an embodiment of the present disclosure, the metal-containing layer may be directly grown on the amorphous boron nitride layer by a deposition process, and the metal-containing layer may be directly grown by an electrochemical deposition.

According to an embodiment of the present disclosure, the metal-containing layer may include at least one selected from a group consisting of: at least one metal selected from a group consisting of lithium (Li), sodium (Na), aluminum (Al), calcium (Ca), silver (Ag), gold (Au), sodium (Na), zinc (Zn), magnesium (Mg), and potassium (K); a sulfide including the metal; a halide; an oxide; an intermetallic compound; and an alloy.

According to an embodiment of the present disclosure, the metal-containing layer may be free of a metal-containing dendrite structure, and the metal-containing layer may be a planar film.

According to an embodiment of the present disclosure, the metal-containing layer may have a thickness of 1 nm to 100 micrometers (µm).

According to an embodiment of the present disclosure, the metal-containing layer may include a lithium metal, a lithium sulfide, a lithium halide, a lithium alloy, or both.

According to an embodiment of the present disclosure, the lithium alloy may include lithium; and at least one selected from a group consisting of sodium (Na), aluminum (Al), calcium (Ca), silver (Ag), gold (Au), sodium (Na), zinc (Zn), magnesium (Mg), and potassium (K).

According to an embodiment of the present disclosure, there is provided a metal battery including: an anode portion; a cathode portion; and an electrolyte between the anode portion and the cathode portion, wherein the anode portion includes an anode current collector, and the anode current collector includes: a current collector substrate; an amorphous boron nitride layer formed on at least one portion of at least one surface of the current collector substrate; and a metal-containing layer formed on at least one portion of the amorphous boron nitride layer.

According to an embodiment of the present disclosure, the electrolyte may include a liquid electrolyte, a solid electrolyte, or both.

According to an embodiment of the present disclosure, the anode current collector may be an anodeless current collector in which the electrolyte contacts the metal-containing layer.

According to an embodiment of the present disclosure, the metal battery may be a lithium metal battery.

According to an embodiment of the present disclosure, there is provided a method of manufacturing an anode current collector, the method including: preparing a current collector substrate; forming an amorphous boron nitride layer on at least one portion of at least one surface of the current collector substrate; and forming a metal-containing layer on at least one portion of the amorphous boron nitride layer.

According to an embodiment of the present disclosure, the forming of the amorphous boron nitride layer may include
transferring the amorphous boron nitride layer onto the anode current collector, and the amorphous boron nitride layer may have a thickness of 10 nm or less.

According to an embodiment of the present disclosure, the forming of the amorphous boron nitride layer may include directly growing an amorphous boron nitride on the anode current collector by a deposition process, and
the amorphous boron nitride layer may have a thickness of 10 nm or less.

According to an embodiment of the present disclosure, the forming of the metal-containing layer may include directly growing the metal-containing layer on the amorphous boron nitride layer by a deposition process.

### Effects

The present disclosure may provide an anode current collector that may suppress a formation of a dendrite structure even though a metal is deposited on a current collector and may have a constant energy density and stability, by modifying a surface of the anode current collector with a metal affinity material, and may provide a lithium metal battery including the same, and a method of manufacturing the same.

### Brief Description of Drawings

FIG. 1A is a scanning electron microscopy (SEM) image of a surface of a lithium metal layer deposited on a current collector, to identify a surface of a lithium metal layer with a dendrite structure deposited on an existing Cu current collector that is not coated with an amorphous boron nitride (a thickness of the amorphous boron nitride: 0 nanometer (nm)), according to an embodiment of the present disclosure.
FIG. 1B is an SEM image of a surface of a surface of a lithium metal layer deposited on a current collector coated with an amorphous boron nitride, to identify a surface of an extremely uniform lithium metal layer deposited on a Cu current collector coated with an amorphous boron nitride having a thickness of 1 nm, according to an embodiment of the present disclosure.
FIG. 1C is an SEM image of a surface of a surface of a lithium metal layer deposited on a current collector coated with an amorphous boron nitride, to identify a surface of a uniform lithium metal layer deposited on a Cu current collector coated with an amorphous boron nitride having a thickness of 3 nm, according to an embodiment of the present disclosure.
FIG. 2A is an optical microscope image measured after an amorphous boron nitride grown on a Cu current collector is transferred onto a SiO₂ surface, according to an embodiment of the present disclosure.
FIG. 2B is an SEM image measured after an amorphous boron nitride grown on a Cu current collector is transferred onto a SiO₂ surface, according to an embodiment of the present disclosure.
FIG. 3 illustrates an optical microscope image of an amorphous boron nitride film, showing points at which a Raman spectroscopy is measured, and Raman spectroscopy measurement results show that an amorphous boron nitride does not have crystallinity at various positions measured within the amorphous boron nitride film, according to an embodiment of the present disclosure.

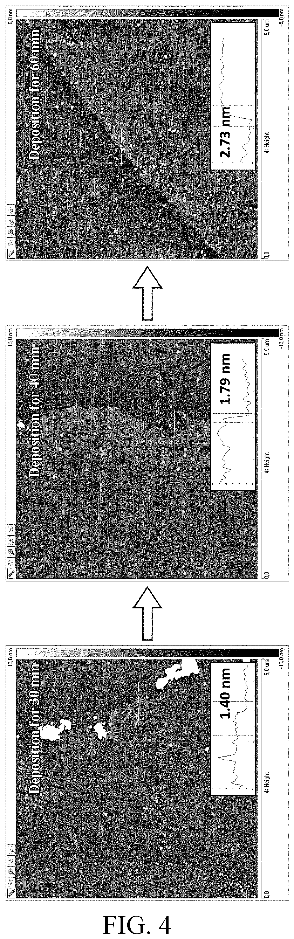

FIG. 4 illustrates atomic force microscopy data to identify a change in a thickness of an applied amorphous boron nitride, depending on a deposition period of time, according to an embodiment of the present disclosure, (a) showing a surface coated with the amorphous boron nitride deposited for 30 minutes (min) using a plasma enhanced chemical vapor deposition (PECVD) and a coating thickness of 1.40 nm, (b) showing a surface coated with the amorphous boron nitride deposited for 40 min using the PECVD and a coating thickness of 1.79 nm, and (c) showing a surface coated with the amorphous boron nitride deposited for 60 min using the PECVD and a coating thickness of 2.73 nm.
FIG. 5A illustrates a B 1s spectrum of an amorphous boron nitride thin film deposited on a Cu current collector, measured by an X-ray photoelectron spectroscopy (XPS), according to an embodiment of the present disclosure.
FIG. 5B illustrates an N 1s spectrum of an amorphous boron nitride thin film deposited on a Cu current collector, measured by an XPS, according to an embodiment of the present disclosure.
FIG. 5C illustrates a Cu 2p spectrum of an amorphous boron nitride thin film deposited on a Cu current collector, measured by an XPS, according to an embodiment of the present disclosure.
FIG. 6 illustrates absorption spectroscopy measurement results of an amorphous boron nitride thin film deposited by a PECVD, according to an embodiment of the present disclosure.
FIG. 7 illustrates a concept of a simulation and comparison of nucleation overpotentials between a Cu current collector, on which an amorphous boron nitride layer is formed, and Cu and Ni current collectors, according to an embodiment of the present disclosure.

### Best Mode for Carrying Out the Invention

Hereinafter, embodiments of the present disclosure will be described in detail with reference to the accompanying drawings. In the description of the present disclosure, detailed description of well-known related functions or configurations will be omitted when it is deemed that such description will cause ambiguous interpretation of the present disclosure. In addition, the terminologies used herein are for the purpose of appropriately describing embodiments of the present disclosure, and may vary depending on the intention of users or operators or customs in the art to which the present disclosure belongs. Therefore, terms used herein should be defined based on the content throughout the present specification. In the drawings, like reference numerals are used for like elements.

In the whole specification, when one member is positioned "on" another member, this not only includes a case that the one member is brought into contact with the other member, but also includes a case that another member exists between two members.

It will be understood throughout the whole specification that, when one part "includes" or "comprises" one component, the part does not exclude other components but may further include the other components.

Hereinafter, an anode current collector, a metal battery, and a method of manufacturing an anode current collector according to the present disclosure will be described in detail with reference to embodiments and drawings. However, the present disclosure is not limited to the embodiments and drawings.

The present disclosure relates to an anode current collector. According to an embodiment of the present disclosure, a surface of the anode current collector may be modified with an amorphous boron nitride as a surface with a metal affinity, for example, a lithiophilic surface. By modifying the surface of the anode current collector to have the metal affinity, a dense and flat metal-containing layer, for example, a lithium metal layer, may be formed on a surface of a current collector even though a formation of a dendrite structure is suppressed or a dendrite structure is not formed, the formation of the dendrite structure may be suppressed even after deposition of the lithium metal layer, and a constant energy density and stability may be provided.

According to an embodiment of the present disclosure, the anode current collector may include a current collector substrate; an amorphous boron nitride layer; and a metal-containing layer.

According to an embodiment of the present disclosure, the current collector substrate may include at least one selected from a group consisting of Ni, Cu, Ti, V, Cr, Mn, Fe, Co, Zn, Mo, W, Ag, Au, Ru, Pt, Ir, Li, Al, Sn, Bi, Sb, and an alloy thereof; calcined carbon; and stainless steel, and may include, for example, a first component including Cu, Ni, Ti, stainless steel, or Al; and a second component (excluding the same element as in the first component) including at least one selected from a group consisting of Ni, Cu, Ti, V, Cr, Mn, Fe, Co, Zn, Mo, W, Ag, Au, Ru, Pt, Ir, Li, Al, Sn, Bi, Sb, and an alloy thereof. The second component may not include the same element as that of the first component, and may form a current collector substrate in the form of a mixture with the first component, a coating, an alloy, a composite, and the like.

In an example of the present disclosure, the current collector substrate may be a foil, a thin film, a film, or a sheet and may have a thickness of 5 micrometers (µm) to 100 µm. If the thickness of the current collector substrate is within the above thickness range, electrons may be advantageously transferred due to a high electrical conductivity of the current collector substrate, and a current collector may be used as a current collector for a lithium metal battery with a high energy density through lithiophilic surface modification.

According to an embodiment of the present disclosure, the amorphous boron nitride layer may be used to modify a surface of the current collector substrate to be a surface with metal affinity, to implement a uniform metal, for example, lithium nucleation by reducing nucleation overpotentials of the surface of the current collector, and to form a metal deposition film with a uniform and dense structure, for example, a lithium metal deposition layer.

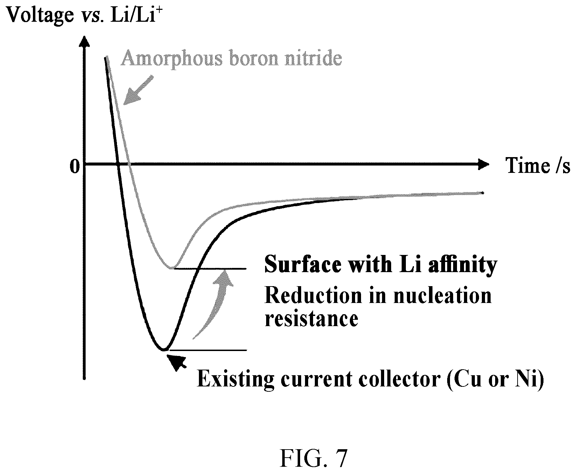

In an example of the present disclosure, the amorphous boron nitride layer may be formed on at least a portion of at least one surface of the current collector substrate and may control metal affinity of the metal-containing layer. In other words, referring to FIG. 7, due to a material modified with an amorphous boron nitride, nucleation overpotentials may be reduced, lithium nucleation resistance may be reduced through improvement of lithium affinity, a formation of a lithium dendrite may be suppressed, a uniform lithium deposition may be possible, and a uniform lithium (layer) deposition may also be possible even at a high current density.

In an example of the present disclosure, the amorphous boron nitride layer may have a thickness of 10 nanometers (nm) or less; 5 nm or less; 3 nm or less; 1 nm or less; 0.1 nm to 1 nm, or an atomic thickness. For example, by applying the atomic thickness, adsorption of metal atoms, for example, lithium atoms, may be advantageous, and an electronic conductivity in a vertical direction from the current collector substrate may be adjustable, thereby controlling a deposition rate of a metal-containing layer, for example, a lithium metal layer, and allowing a uniform and dense lithium metal layer to be formed.

In an example of the present disclosure, the amorphous boron nitride layer may have a planar shape with the atomic thickness or the above-described thickness range, which may indicate a formation of an amorphous boron nitride with a thickness that allows a metal atom to be adsorbed.

According to an embodiment of the present disclosure, the metal-containing layer may be formed on at least a portion of the amorphous boron nitride layer and may be directly grown or transferred on the amorphous boron nitride layer by a deposition process. For example, lithium nucleation resistance of the lithium metal layer may be greatly reduced on the amorphous boron nitride layer, so that deposition of lithium with a dendrite structure may be suppressed, to enable uniform lithium metal deposition and uniform lithium nucleation in an atomic unit and large area, thereby forming a large-area lithium metal layer. In addition, since the lithium metal layer is uniformly and densely deposited, a side reaction may be suppressed and a formation and growth of lithium dendrites may be suppressed at a high current.

In an example of the present disclosure, the metal-containing layer may be directly grown on the surface of the current collector modified with the amorphous boron nitride layer, and accordingly, nucleation overpotentials of a metal may be reduced and a metal-containing layer with a flat and dense structure in which a dendrite structure is suppressed may be formed on the surface of the current collector. In other words, a metal-containing layer of a planar film with a dense and flat structure may be formed, so that a constant energy density and stability may be enhanced. In addition, by suppressing a formation of a metal dendrite structure, the metal-containing layer may have little or no metal dendrite structure or may be free of the metal dendrite structure. The metal-containing layer may be formed as a uniform and dense film, to suppress a side reaction at a high current and suppress a formation of dendrites during operating of a battery.

In an example of the present disclosure, the metal-containing layer may include at least one selected from a group consisting of: at least one metal selected from a group consisting of lithium (Li), sodium (Na), aluminum (Al), calcium (Ca), silver (Ag), gold (Au), sodium (Na), zinc (Zn), magnesium (Mg), and potassium (K); a compound containing the metal (or metal element); and an alloy. For example, the compound containing the metal (or metal element) may be a sulfide, a halide, an oxide, and the like.

In an example of the present disclosure, the metal-containing layer may be a lithium metal layer, and the lithium metal layer may include at least one selected from a group consisting of a lithium metal, a lithium-containing compound, a lithium-containing intermetallic compound, and a lithium alloy.

For example, the lithium-containing compound may be a sulfide, a halide, an oxide, and the like, and may be, for example, a lithium sulfide (e.g., LiS), a lithium halide (e.g., LiF), a lithium oxide (e.g., LiO₂), and the like.

For example, the lithium alloy and intermetallic compound may include, for example, lithium; and at least one selected from a group consisting of sodium (Na), aluminum (Al), calcium (Ca), silver (Ag), gold (Au), sodium (Na), zinc (Zn), magnesium (Mg), and potassium (K).

For example, the lithium metal layer may further include at least one metal (or element) selected from a group consisting of sodium (Na), aluminum (Al), calcium (Ca), silver (Ag), gold (Au), sodium (Na), zinc (Zn), magnesium (Mg), and potassium (K).

In an example of the present disclosure, the metal-containing layer may have a thickness of 1 nm to 100 micrometers (µm); 10 nm to 50 µm; or 1 µm to 40 µm; or 10 µm to 35 µm, or may have an atomic thickness. When the thickness of the metal-containing layer is included within the above thickness range or the metal-containing layer is formed with a thinner thickness within the above thickness range, the metal-containing layer may be advantageous in increasing the energy density in units of cells.

The present disclosure relates to a metal battery. According to an embodiment of the present disclosure, the lithium metal battery may include: an anode portion; a cathode portion; and an electrolyte between the anode portion and the cathode portion. The anode current collector according to the present disclosure may be applied to the lithium metal battery, and accordingly, the lithium metal battery may exhibit a high energy density, a high stability, and long lifespan characteristics.

According to an embodiment of the present disclosure, the metal battery may be lithium (Li), sodium (Na), aluminum (Al), calcium (Ca), silver (Ag), gold (Au), sodium (Na), zinc (Zn), magnesium (Mg), or potassium (K)-based metal battery.

According to an embodiment of the present disclosure, the anode may include an anode current collector according to the present disclosure, and the anode current collector may be an anodeless current collector by applying the metal-containing layer.

According to an embodiment of the present disclosure, the electrolyte may include an electrolyte applicable to a metal battery known in a technical field of the present disclosure, may be formed between the cathode and the metal-containing layer of the anode current collector, and may include a liquid electrolyte, a solid electrolyte, or both. A separator may be further included between the electrolyte and the cathode. The separator may include a liquid electrolyte, a solid electrolyte, or both, and may be applied as a function of the electrolyte.

In an example of the present disclosure, the electrolyte may form an anodeless metal battery in contact with the metal-containing layer and may form, for example, an anodeless lithium metal battery.

According to an embodiment of the present disclosure, as the cathode, all cathodes applicable to a metal battery known in the technical field of the present disclosure may be applied without limitation, and the cathode may be a high-capacity cathode such as an oxide or a sulfide. The cathode may further include a cathode current collector.

In an example of the present disclosure, for the metal battery, a configuration for an operation and driving known in the technical field of the present disclosure may be introduced without departing from the aspect and scope of the present disclosure, and further description thereof is omitted herein.

The present disclosure relates to a method of manufacturing an anode current collector according to the present disclosure. According to an embodiment of the present disclosure, in the method, a surface of a current collector substrate may be modified with an amorphous boron nitride to have metal affinity, and a metal-containing layer may be directly grown on the current collector, to form a uniform and dense metal-containing film in which a generation of a dendrite structure is suppressed.

According to an embodiment of the present disclosure, the method may include: a step of preparing a current collector substrate; a step of forming an amorphous boron nitride layer on at least a portion of at least one surface of the current collector substrate; and a step of forming a metal-containing layer on at least a portion of the amorphous boron nitride layer.

According to an embodiment of the present disclosure, the step of forming the amorphous boron nitride layer may be performed by a physical method or a chemical method. For example, the physical method may include a step of transferring the amorphous boron nitride layer onto the anode current collector, and a two-dimensional material grown on a separate substrate may be exfoliated by an electrical exfoliation scheme and transferred onto the current collector substrate. A transferring method known in the technical field of the present disclosure may be applied to the step of transferring the amorphous boron nitride layer, and further description thereof is omitted herein.

For example, the chemical method may include a step of directly growing the amorphous boron nitride layer on the anode current collector by a deposition process, and the amorphous boron nitride may be directly grown on the current collector substrate using a chemical vapor deposition (CVD). As the chemical method, an atomic layer deposition (ALD), a plasma atomic layer deposition, a plasma enhanced chemical vapor deposition (PECVD), and the like may be further used.

For example, the step of forming the amorphous boron nitride layer may be performed at a temperature of room temperature to 700°C; room temperature to 500°C; 50°C to 500°C; 100°C to 500°C; or 100°C to 450°C. In addition, growing may be performed under an atmospheric pressure or vacuum state.

According to an embodiment of the present disclosure, the step of forming the metal-containing layer may be directly growing the metal-containing layer on the amorphous boron nitride layer by a deposition process, and the metal-containing layer may be directly grown on the current collector substrate having the surface modified by the amorphous boron nitride layer, using, for example, an electrochemical deposition, a physical adsorption (e.g., press, etc.), alloying (e.g., a melting and alloying reaction, such as "melting & alloy"), and the like.

For example, the step of forming the metal-containing layer may be performed at a temperature of room temperature to 100°C; room temperature to 90°C; room temperature to 50°C; room temperature to 40°C. In addition, growing may be performed under an atmospheric pressure or vacuum state.

The present disclosure may provide a method of manufacturing a metal battery by introducing or utilizing the anode current collector or the method of manufacturing the anode current collector according to the present disclosure. For example, a step of preparing the anode current collector; a step of preparing an electrolyte and/or a separator; a step of preparing a cathode; and a step of connecting, combining, attaching, and/or compressing the anode current collector, the electrolyte and/or separator, and the cathode by arranging the anode current collector, the electrolyte and/or separator, and the cathode in order.

Although the present disclosure is described with reference to desired embodiments, the present disclosure is not limited thereto. Various changes and modifications may be made without departing from the spirit and scope of the present disclosure disclosed in the following claims, the detailed description, and the accompanying drawings.

### Examples

### Preparation Example 1

A monolayer having an atomic thickness of an amorphous boron nitride was prepared and transferred onto a current collector.

### Preparation Example 2

An amorphous boron nitride was directly grown on a Cu foil by a PECVD method (temperature: 500°C, and pressure: 120 mTorr), to form an amorphous boron nitride film having an atomic thickness on a surface of a Cu current collector.

### Preparation Example 3

### Fabrication of Electrochemical Cell including Lithium Metal - Anode Current Collector

Through an electrochemical deposition process on surfaces of anode current collectors prepared in Preparation Examples 1 to 3 on which amorphous boron nitride films are formed, a lithium metal layer having a desired thickness was deposited on the anode current collectors, to fabricate an electrochemical cell. Next, a separator and an electrolyte were added.

### Current collector: Pristine Cu, a-BN Monolayer/Cu

### Electrolyte: 1 M LiTFSI in 1,3-dioxolane (DOL)/1,2-dimethyoxyethane (DME) = 1/1 (v/v) + 2 wt% LiNO₃

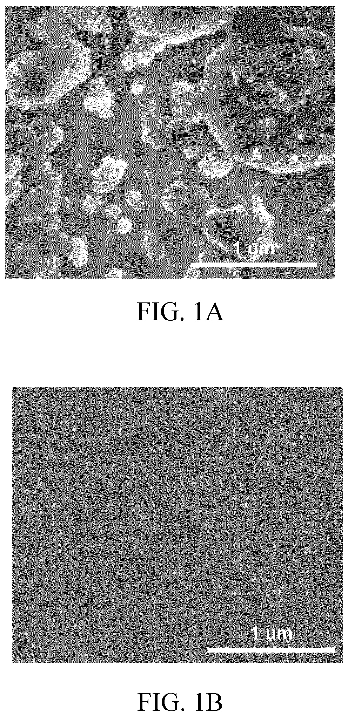

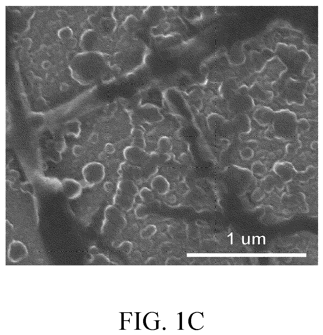

Surface characteristics and crystallographic characteristics of the prepared current collectors are analyzed and shown in FIGS. 1 to 6.

FIGS. 1A to 1C are scanning electron microscopy (SEM) images of surfaces of deposited lithium metals, according to an embodiment of the present disclosure, FIGS. 1A and 1B show SEM images after electrochemical deposition of Li metals ((0.1 mAh/cm²) on pristine Cu, and on a-BN (1 nm)/Cu and a-BN (3 nm)/Cu, and surface morphologies were compared. It can be confirmed that the most uniform Li metal deposition was achieved on the a-BN (1 nm)/Cu.

In other words, it can be confirmed that almost no dendrite structure was formed from an image of a lithium layer formed on the a-BN (1 nm)/Cu, whereas a dendrite structure is shown in an image of a lithium layer formed on a Cu current collector. Thus, it can be found that a dense and flat lithium layer without lithium having a dendrite structure may be formed on a surface of a current collector due to a reduction in lithium nucleation resistance of the Cu current collector coated with the amorphous boron nitride.

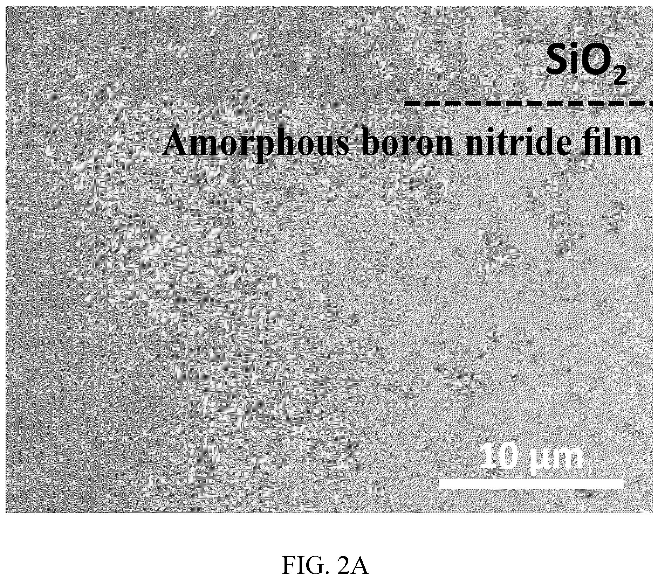

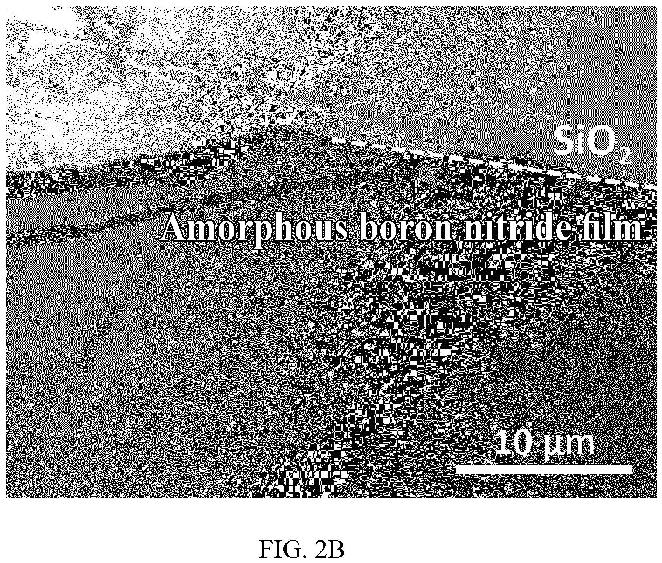

FIGS. 2A and 2B are an optical microscope image and an SEM image that are measured after an amorphous boron nitride film grown on a Cu current collector is transferred onto a SiO₂ surface, and it can be confirmed that it has amorphous characteristics without crystallinity.

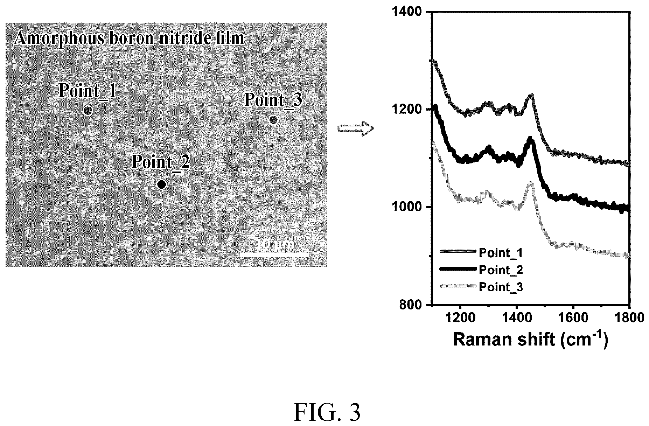

FIG. 3 illustrates Raman spectroscopy results at various positions of an amorphous boron nitride film, according to an embodiment of the present disclosure, and it can be confirmed, based on the Raman spectroscopy results, that the amorphous boron nitride film does not have crystallinity.

FIG. 4 illustrates atomic force microscopy data to identify a change in a thickness of a deposited amorphous boron nitride film, which is deposited on a Cu current collector, depending on a deposition period of time, according to an embodiment of the present disclosure, (a) shows a surface of an amorphous boron nitride film deposited for 30 minutes (min) using a PECVD and a film thickness of 1.40 nm, (b) shows a surface of an amorphous boron nitride film deposited for 40 min using the PECVD and a film thickness of 1.79 nm, and (c) shows a surface of an amorphous boron nitride film deposited for 60 min using the PECVD and a film thickness of 2.73 nm.

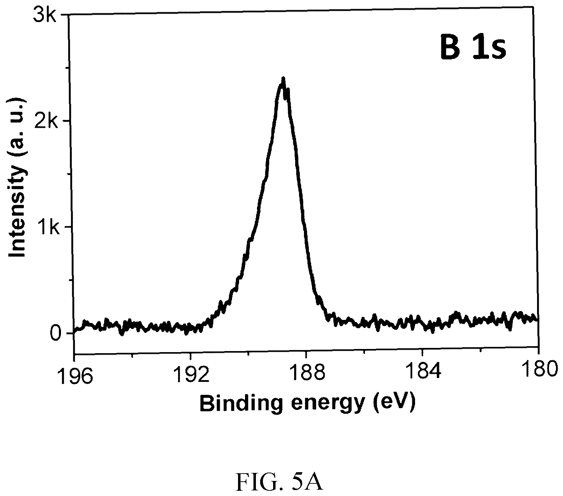

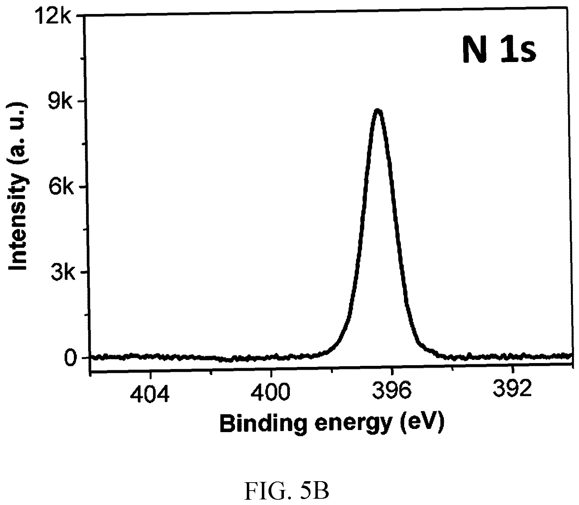

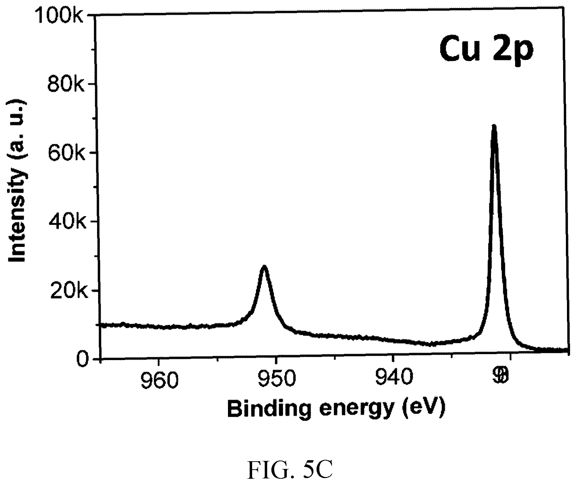

Referring to FIGS. 5A to 5C, it can be confirmed that amorphous boron nitrides were formed from a B 1s spectrum, an N 1s spectrum, and a Cu 2p spectrum of an amorphous boron nitride thin film deposited on a Cu current collector measured by an X-ray photoelectron spectroscopy (XPS), according to an embodiment of the present disclosure.

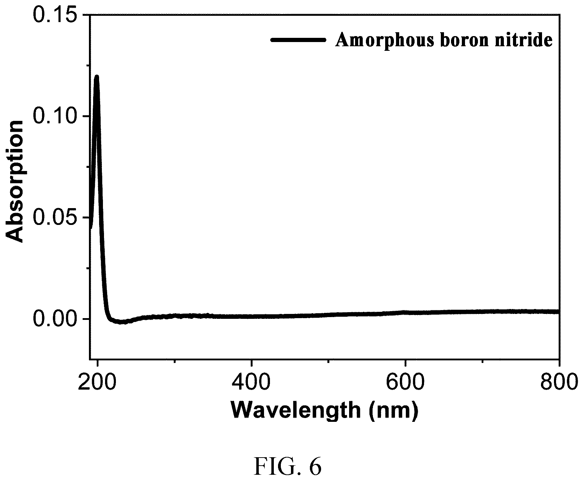

FIG. 6 illustrates absorption spectroscopy measurement results of an amorphous boron nitride thin film, according to an embodiment of the present disclosure, and it can be confirmed, based on an absorption of light at a wavelength of 190 nm, that an amorphous boron nitride was formed.

The present disclosure may provide an anode current collector having a surface is treated with a material having a lithium affinity and an atomic thickness (10 nm or less), and may provide an anode current collector that may suppress a deposition of lithium with a lithium dendrite structure, that may reduce lithium nucleation resistance during a deposition of a lithium metal through improvement of a lithium affinity of a surface of the anode current collector, and that may allow lithium to be uniformly deposited even at a high current density. In addition, the anode current collector may have a constant energy density and stability and may be used as an anodeless current collector of a lithium metal battery with a high energy density.

While the embodiments are described with reference to drawings, it will be apparent to one of ordinary skill in the art that various alterations and modifications in form and details may be made in these embodiments without departing from the spirit and scope of the claims and their equivalents. For example, suitable results may be achieved if the described techniques are performed in a different order, and/or if described components are combined in a different manner, and/or replaced or supplemented by other components or their equivalents. Therefore, other implementations, other embodiments, and equivalents to the claims are also within the scope of the following claims.

## Claims

1. An anode current collector comprising:
a current collector substrate;
an amorphous boron nitride layer formed on at least a portion of at least one surface of the current collector substrate; and
a metal-containing layer formed on at least a portion of the amorphous boron nitride layer.

2. The anode current collector of claim 1, wherein the current collector substrate comprises at least one selected from a group consisting of Ni, Cu, Ti, V, Cr, Mn, Fe, Co, Zn, Mo, W, Ag, Au, Ru, Pt, Ir, Li, Al, Sn, Bi, Sb, and an alloy thereof; calcined carbon; and stainless steel.

3. The anode current collector of claim 1, wherein the current collector
substrate comprises:
a first component including Cu, Ni, Ti, stainless steel, or Al; and
a second component (excluding a same element as in the first component) including at least one selected from a group consisting of Ni, Cu, Ti, V, Cr, Mn, Fe, Co, Zn, Mo, W, Ag, Au, Ru, Pt, Ir, Li, Al, Sn, Bi, Sb, and an alloy thereof.

4. The anode current collector of claim 1, wherein the amorphous boron nitride layer has a thickness of 10 nanometers (nm) or less.

5. The anode current collector of claim 1, wherein the amorphous boron nitride layer has a thickness of 0.1 nm to 1 nm.

6. The anode current collector of claim 1, wherein the amorphous boron nitride layer has an atomic thickness.

7. The anode current collector of claim 1, wherein
the metal-containing layer is directly grown on the amorphous boron nitride layer by a deposition process, and
the metal-containing layer is directly grown by an electrochemical deposition.

8. The anode current collector of claim 1, wherein the metal-containing layer comprises at least one selected from a group consisting of:
at least one metal selected from a group consisting of lithium (Li), sodium (Na), aluminum (Al), calcium (Ca), silver (Ag), gold (Au), sodium (Na), zinc (Zn), magnesium (Mg), and potassium (K); a sulfide including the metal; a halide; an oxide; an intermetallic compound; and an alloy.

9. The anode current collector of claim 1, wherein
the metal-containing layer is free of a metal-containing dendrite structure, and
the metal-containing layer is a planar film.

10. The anode current collector of claim 1, wherein the metal-containing layer has a thickness of 1 nm to 100 micrometers (µm).

11. The anode current collector of claim 1, wherein the metal-containing layer comprises a lithium metal, a lithium sulfide, a lithium halide, a lithium alloy, or both.

12. The anode current collector of claim 11, wherein the lithium alloy comprises: lithium; and at least one selected from a group consisting of sodium (Na), aluminum (Al), calcium (Ca), silver (Ag), gold (Au), sodium (Na), zinc (Zn), magnesium (Mg), and potassium (K).

13. A metal battery comprising:
an anode portion;
a cathode portion; and
an electrolyte between the anode portion and the cathode portion,
wherein the anode portion comprises an anode current collector,
wherein the anode current collector comprises:
a current collector substrate;
an amorphous boron nitride layer formed on at least a portion of at least one surface of the current collector substrate; and
a metal-containing layer formed on at least a portion of the amorphous boron nitride layer.

14. The metal battery of claim 13, wherein the electrolyte comprises a liquid electrolyte, a solid electrolyte, or both.

15. The metal battery of claim 13, wherein the anode current collector is an anodeless current collector in which the electrolyte contacts the metal-containing layer.

16. The metal battery of claim 13, wherein the metal battery is a lithium metal battery.

17. A method of manufacturing an anode current collector, the method comprising:
preparing a current collector substrate;
forming an amorphous boron nitride layer on at least a portion of at least one surface of the current collector substrate; and
forming a metal-containing layer on at least a portion of the amorphous boron nitride layer.

18. The method of claim 17, wherein
the forming of the amorphous boron nitride layer comprises transferring the amorphous boron nitride layer onto the anode current collector, and the amorphous boron nitride layer has a thickness of 10 nanometers (nm) or less.

19. The method of claim 17, wherein
the forming of the amorphous boron nitride layer comprises directly growing an amorphous boron nitride on the anode current collector by a deposition process, and
the amorphous boron nitride layer has a thickness of 10 nm or less.

20. The method of claim 17, wherein the forming of the metal-containing layer comprises directly growing the metal-containing layer on the amorphous boron nitride layer by a deposition process.
